# EUROPEAN PATENT APPLICATION

(11) **EP 4 678 784 A1**
(43) Date of publication of application: **14.01.2026**
(21) Application number: 24766455.0
(22) Date of filing: 06.03.2024
(51) Int. Cl.: C23C 16/44

(54) **PROCESS CHAMBER, SEMICONDUCTOR PROCESSING DEVICE, AND BEARING PLATFORM CALIBRATION METHOD**

(30) Priority: 09.03.2023 CN 202310248364
(71) Applicant: Beijing NAURA Microelectronics Equipment Co., Ltd., Beijing 100176 (CN)
(72) Inventor: ZHAO, Dongyue, Beijing 100176 (CN)
(74) Representative: Cohausz & Florack
(86) International application number: PCT/CN2024/080217
(87) International publication number: WO 2024/183740

(57) **Abstract**

The present disclosure provides a calibration method for a process chamber, semiconductor processing device, and a carrying platform. The process chamber includes a chamber body and at least one process station disposed within the chamber body. Each process station includes a carrying platform movably connected to the chamber body and a spray assembly disposed directly above the carrying platform. The process chamber also includes: at least one first distance measuring module disposed on the spray assembly, which is used to measure a first distance between itself and a wafer on the carrying platform; and a first drive source connected to the carrying platform, which is used to drive the carrying platform to move up and down according to the first distance. The present disclosure can calibrate the gap value in real time to ensure film thickness consistency between wafers in different batches or at different workstations.

## Description

### FIELD OF THE TECHNOLOGY

The present disclosure relates to, but is not limited to, a technical field of semiconductor manufacturing equipment, and in particular to a process chamber, semiconductor processing device, and a calibration method for a carrying platform.

### BACKGROUND

Plasma-enhanced chemical vapor deposition (PECVD) equipment can be used for dielectric thin film deposition processes. For example, it can grow dielectric films primarily composed of Si, O, and N on wafer surfaces, as well as deposit doped films containing boron and phosphorus. Film thickness consistency is a critical performance characteristic of semiconductor processing equipment. For example, it is necessary to maintain consistent film thickness across wafers produced at different times. This is even more critical for chambers with twin deposition process stations, where film thickness consistency across wafers at different process stations within a single process must be maintained. A process station is a location where deposition or etching processes are performed on a wafer. Each process station processes a single wafer, and multiple process stations can process multiple wafers simultaneously to improve production efficiency.

The gap between the wafer and the showerhead (the top electrode) is a key factor in ensuring film thickness consistency across wafers. One such gap calibration method uses an inter-wafer gap measurement system (AGS) to measure and calibrate the gap. Three modules are distributed on the AGS plane. Once the AGS is placed in the chamber, the three modules measure the gap values at corresponding locations. If the difference between the three gap values and the set values is ≤0.1mm, calibration is considered acceptable. Otherwise, further calibration is required.

The above gap calibration method only guarantees accurate gap values upon tool assembly. However, as the equipment is used, the surfaces of the carrying plate or showerhead may accumulate deposits or material may fall off, causing the gap values to fluctuate. There is no guarantee that the actual gap values will always meet process standards. Gap value fluctuations can affect the consistency of film thickness between wafers in different batches or at different process locations.

### SUMMARY

To address the aforementioned technical issues, the present disclosure provides a process chamber, semiconductor processing device, and a calibration method for a carrying platform. These methods can address the problem in related art of failing to ensure that the wafer-to-showerhead spacing consistently meets the design target during processing, resulting in poor film thickness consistency across wafers in different batches or at different process stations.

To address the aforementioned technical issues, in a first aspect, embodiments of the present disclosure provide a process chamber including a chamber body and at least one process station disposed within the chamber body. Each process station includes a carrying platform movably connected to the chamber body and a spray assembly disposed directly above the carrying platform. The process chamber also includes:

At least one first distance measuring module disposed on the spray assembly for measuring a first distance between the module and the wafer on the carrying platform;

A first drive source connected to the carrying platform for driving the carrying platform to move upward and downward based on the first distance.

In some embodiments, the spray assembly includes:

A gas distribution plate having a plurality of gas distributing holes connected to the interior of the chamber body; the gas distribution plate including a transparent portion disposed to avoid the gas distribution holes; and the first distance measuring modules being disposed in a one-to-one correspondence with the transparent portion.

In some embodiments, the spray assembly also includes:
A sealing cover disposed over the gas distribution plate to form a gas distributing cavity therebetween; the sealing cover having a gas inlet for introducing gas into the gas distributing cavity.

In some embodiments, the spray assembly also includes: An isolation pipe disposed within the gas distributing cavity; the isolation pipe having an inlet end and an outlet end corresponding to the at least one first distance measuring module; the outlet end housing the corresponding first distance measuring module within the isolation pipe; the sealing cover also having a connection hole, the inlet end being located at the connection hole; and the isolation pipe accommodating a cable of the first distance measuring module.

In some embodiments, the gas distribution plate includes at least two gas distribution regions, including a first gas distribution region without the first distance measuring module and a second gas distribution region with the first distance measuring module.

The gas outlets of the gas distribution holes in the first gas distribution region are smaller than the gas outlets of the gas distribution holes in the second gas distribution region.

In some embodiments, the gas distribution holes in the first gas distribution region are straight holes;
The gas distribution holes in the second gas distribution region have outwardly flaring conical outlets.

In some embodiments, the first gas distribution region includes an inner circle and outer circle gas distribution regions, and the second gas distribution region includes a middle circle gas distribution region.

The middle circle gas distribution region surrounds the inner circle gas distribution region, and the outer circle gas distribution region surrounds the middle circle gas distribution region.

In some embodiments, the carrying platform includes a carrying plate and a support base. The support base extends through the bottom plate of the chamber body and is movably connected to the bottom plate. The carrying plate is mounted on the top surface of the support base.

The first drive source is located outside the chamber body and is configured to drive the support base to cause the carrying plate to move upward and downward.

In some embodiments, the process chamber further includes a fixed plate disposed outside the chamber body, the fixed plate being provided with a vertically extending sliding groove.

The carrying platform further includes a mounting plate connected to a portion of the support base located outside the chamber body, and a slider engaged with the sliding groove, the slider being connected to the mounting plate.

The first drive source is connected to the slider and/or the mounting plate to enable the slider to move up and down along the sliding groove.

In some embodiments, the carrying platform further includes a connecting bracket;
A first leveling mechanism is connected to the mounting plate and one end of the connecting bracket, respectively, for adjusting the horizontality of the support base in a first direction via the mounting plate;
A second leveling mechanism is connected to the slider and the other end of the connecting bracket, respectively, for adjusting the horizontality of the support base in a second direction via the connecting bracket, where the second direction is perpendicular to the first direction.

In some embodiments, the first leveling mechanism includes:
At least two second distance measuring modules arranged along the first direction on the top surface of the mounting plate, the second distance measuring modules being configured to measure a second distance between themselves and the base plate;
A second drive source, disposed on the connecting bracket and connected to the mounting plate, for driving the mounting plate to swing about a horizontal axis of the mounting plate parallel to the second direction based on the second distance; and/or
The second leveling mechanism includes:
   At least two third distance measuring modules arranged along the second direction on the top surface of the mounting plate, the third distance measuring modules being configured to measure a third distance between themselves and the base plate;
   A third drive source, disposed on the slider and connected to the other end of the connecting bracket, for driving the mounting plate to swing about a horizontal axis of the mounting plate parallel to the first direction based on the third distance through the connecting bracket.

In a second aspect, embodiments of the present disclosure provide a semiconductor processing device including a process chamber as described in the above embodiments.

In a third aspect, embodiments of the present disclosure provide a method for calibrating a carrying platform based on the process chamber as described in the above embodiments. The method includes a gap calibration process, including:
Controlling the first distance measuring module to measure a first distance between itself and a wafer on the carrying platform;
Calculating a gap value between the spray assembly and the wafer based on the first distance, and calculating a first absolute value of the difference between the gap value and a preset gap target value;
If the first absolute value is greater than a preset gap error lower limit and less than or equal to a preset gap error upper limit, controlling the first drive source to drive the carrying platform upward or downward, and returning to the process of controlling the first distance measuring module to measure the first distance between itself and the wafer on the carrying platform until the first absolute value is less than or equal to the preset gap error lower limit.

In some embodiments, after calculating the gap between the spray assembly and the wafer based on the first distance and calculating a first absolute value of the difference between the gap value and a preset gap target value, the method further includes:
If the first absolute value is greater than a preset gap error upper limit, determining that the process chamber is abnormal.

In some embodiments, the gap calibration process also includes a horizontal calibration process before the gap calibration process. The horizontal calibration process includes:
Controlling the second distance measuring module to measure the second distance between itself and the bottom plate;
Calculating a second absolute value of the difference between the second distances measured by the second distance measuring module;
If the second absolute value is greater than a preset horizontal error value, controlling the second drive source to drive the mounting plate to swing about a horizontal axis parallel to the second direction, and returning to the process of controlling the second distance measuring module to measure the second distance between itself and the bottom plate until the second absolute value is less than or equal to the preset horizontal error value.

In some embodiments, before controlling the second distance measuring module to measure the second distance between itself and the base plate, or after controlling the second distance measuring module to swing about a horizontal axis parallel to the second direction, and returning to the process of controlling the second distance measuring module to measure the second distance between itself and the bottom plate until the second absolute value is less than or equal to the preset horizontal error value, the process also includes:
Controlling the third distance measuring module to measure the third distance between itself and the bottom plate;
Calculating a third absolute value of the difference between the third distance measured by the third distance measuring module;
If the third absolute value is greater than the preset horizontal error value, the third drive source is controlled to drive the mounting plate to swing about a horizontal axis parallel to the first direction. The third distance measuring module is then controlled to measure the third distance between the mounting plate and the bottom plate until the third absolute value is less than or equal to the preset horizontal error value, where the second direction is perpendicular to the first direction.

As described above, the process chamber disclosed herein utilizes at least one first distance measuring module in the spray assembly. The first distance measuring module measures the first distance between the mounting plate and the wafer on the carrying platform. Based on this first distance, a gap value is derived. The first drive source drives the carrying platform to move upward and downward to calibrate the gap value if the gap value exceeds the preset gap target error range. Throughout the entire process, the first distance measured in real time by the first distance measuring module allows for timely gap calibration, thereby ensuring consistent film thickness across wafers in different batches or at different process locations. This embodiment not only enables real-time gap calibration during the process but is also suitable for pre-process tool calibration, eliminating the need for repeated chamber opening measurements and simplifying calibration. In addition, in this embodiment, the measurement of the Gap calibration process is based on the fixed spray assembly, and the accuracy is relatively high, which can reach above 0.1mm level.

### BRIEF DESCRIPTION OF THE DRAWINGS

The accompanying drawings herein are incorporated into and constitute a part of the present disclosure. They illustrate embodiments consistent with the present disclosure and, together with the description, serve to explain the principles of the present disclosure. To more clearly illustrate the technical solutions of the embodiments of the present disclosure, the following briefly describes the drawings required for describing the embodiments. Obviously, those skilled in the art can derive other drawings based on these drawings without inventive effort.
FIG. 1 is a schematic diagram illustrating the relationship between the spacing and the distance traveled by the carrying plate.
FIG. 2 is a schematic diagram illustrating the structure of a process chamber according to an embodiment of the present disclosure.
FIG. 3 is a schematic diagram illustrating the structure of a spray assembly according to an embodiment of the present disclosure.
FIG. 4 is a schematic diagram illustrating the structure of a gas distribution plate according to an embodiment of the present disclosure.
FIG. 5 is a schematic diagram illustrating a longitudinal cross-section of a first through-hole according to an embodiment of the present disclosure.
FIG. 6 is a schematic diagram illustrating a longitudinal cross-section of a second through-hole according to an embodiment of the present disclosure.
FIG. 7 is a schematic diagram illustrating a cross-sectional view taken along line A-A in FIG. 2.
FIG. 8 is a schematic diagram illustrating the structure of a control system according to an embodiment of the present disclosure.
FIG. 9 is a schematic flow chart illustrating a gap calibration method according to an embodiment of the present disclosure.
FIG. 10 is a schematic flow chart illustrating another gap calibration method according to an embodiment of the present disclosure.
FIG. 11 is a schematic flow chart illustrating a first-direction horizontal calibration method according to an embodiment of the present disclosure.
FIG. 12 is a schematic flow chart illustrating a second-direction horizontal calibration method according to an embodiment of the present disclosure.
FIG. 13 is a schematic flow chart illustrating a horizontal calibration method according to an embodiment of the present disclosure.

The achievement of the objectives, functional features, and advantages of the present disclosure will be further illustrated with reference to the accompanying drawings in conjunction with the embodiments. The above drawings illustrate specific embodiments of the present disclosure, which will be described in more detail below. These drawings and textual descriptions are not intended to limit the scope of the present disclosure in any way, but rather to illustrate the concepts of the present disclosure to those skilled in the art by reference to specific embodiments.

### DETAILED DESCRIPTION

Exemplary embodiments will be described in detail herein, as illustrated in the accompanying drawings. When the following description refers to the drawings, identical numerals in different figures represent identical or similar elements, unless otherwise indicated. The embodiments described in the following exemplary embodiments do not represent all embodiments consistent with the present disclosure. Rather, they are merely examples of devices and methods consistent with certain aspects of the present disclosure, as detailed in the appended claims.

It should be noted that, as used herein, the terms "comprise," "include," or any other variations thereof are intended to encompass non-exclusive inclusion, such that a process, method, article, or device comprising a list of elements includes not only those elements but also other elements not expressly listed, or elements inherent to such process, method, article, or device. Without further limitation, an element specified by the phrase "comprising a..." does not preclude the presence of additional identical elements in the process, method, article, or device comprising that element. Furthermore, components, features, and elements with the same name in different embodiments of the present disclosure may have the same or different meanings, and their specific meanings are determined by their interpretation in that specific embodiment or by further contextualization of that embodiment.

It should be further understood that the terms "comprising" and "including" indicate the presence of the described features, steps, operations, elements, components, items, kinds, and/or groups, but do not exclude the presence, occurrence, or addition of one or more other features, steps, operations, elements, components, items, kinds, and/or groups. The terms "or", "and/or", "including at least one of the following", etc. used in this disclosure may be interpreted as inclusive, or mean any one or any combination. For example, "including at least one of the following: A, B, C" means "any one of the following: A; B; C; A and B; A and C; B and C; A and B and C", and for another example, "A, B or C" or "A, B and/or C" means "any one of the following: A; B; C; A and B; A and C; B and C; A and B and C". Exceptions to this definition will only occur when the combination of elements, functions, steps or operations is inherently mutually exclusive in some way.

It should be understood that while terms such as "first," "second," and "third" may be used herein to describe various types of information, such information should not be limited to these terms. These terms are used solely to distinguish information of the same type from one another. For example, first information could be referred to as second information, and similarly, second information could be referred to as first information, without departing from the scope of this disclosure. Depending on the context, as used herein, the singular forms "a," "an," and "the" are intended to include the plural forms as well, unless the context indicates otherwise.

It should be understood that terms such as "top," "bottom," "upper," "lower," "vertical," and "horizontal" indicate positions or locations based on the positions or locations shown in the accompanying drawings. These terms are intended solely to facilitate description and simplify the present disclosure, and are not intended to indicate or imply that the devices referred to must have, be constructed, or operate in a specific orientation. Therefore, they should not be construed as limiting the present disclosure.

For ease of description, the following embodiments are described using the orthogonal space formed by the horizontal and vertical directions as an example. This premise should not be construed as limiting the present disclosure.

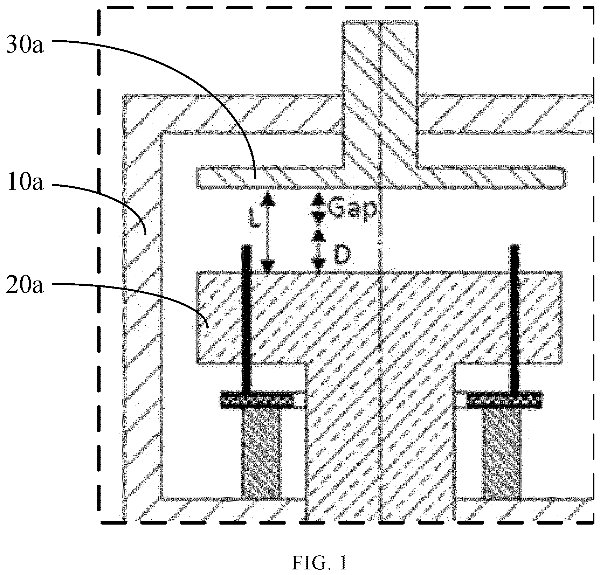

When semiconductor processing device performs deposition or etching processes, the gap between the wafer and the showerhead (Gap value) is a critical factor in ensuring consistent film thickness across wafers. Please refer to FIG. 1, which illustrates the relationship between the gap and the distance traveled by the carrying plate. The initial distance between the carrying plate 20a and the showerhead 30a is L, relative to the chamber body 10a. During processing, a wafer (not shown) is placed on the carrying plate 20a and ascends a distance D with the carrying plate 20a. The gap between the top surface of the carrying plate 20a and the bottom surface of the showerhead 30a is the Gap value. Taking into account the wafer thickness (T), Gap = L - D - T. While the Gap value is manually calibrated before processing, as the device is used, deposits or material may fall off the surfaces of the carrying plate or showerhead, causing the Gap value to fluctuate. It is impossible to guarantee that the actual Gap value will always meet process standards. Gap value fluctuations can affect the consistency of film thickness across wafers from different batches or at different processing positions. Based on this, the present disclosure provides a process chamber, semiconductor processing device, and a calibration method for a carrying platform. The following embodiments are described using deposition processing device as an example and should not be construed as limiting the present disclosure.

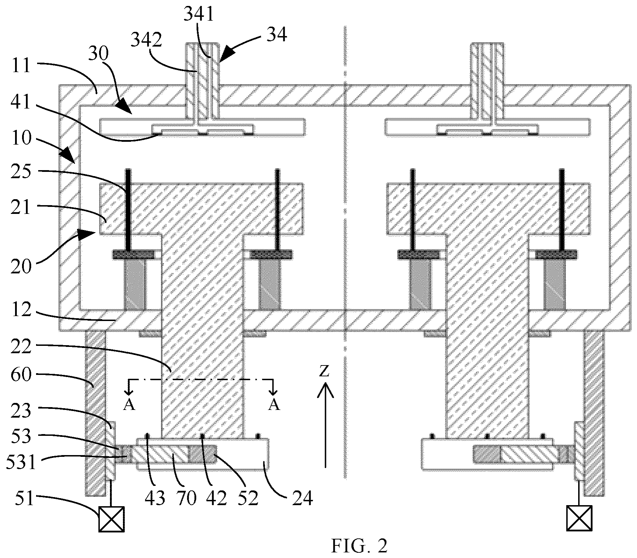

Please refer to FIG. 2, which is a schematic structural diagram of a process chamber according to an embodiment of the present disclosure. The process chamber includes a chamber body 10 and at least one process station disposed within the chamber body 10. This process station may be, for example, a deposition process station. The process chamber of this embodiment may include only one deposition process station, or two, three, or more deposition process stations. FIG. 2 uses two deposition process stations within the process chamber as an example. Since the two deposition process stations can be identical, only one is labeled. Each deposition process station may include a carrying platform 20, a spray assembly 30, at least one first distance measuring module 41, and a first drive source 51.

The carrying platform 20 is movably connected to the chamber body 10. For example, the carrying platform 20 can be raised and lowered relative to the chamber body 10 to adjust its height. Alternatively, the carrying platform 20 can be swung relative to the chamber body 10 to adjust its level. The carrying platform 20 is used to support wafers and, for example, is equipped with a heater to heat the carrying platform 20. Ejector pins 25 can also be provided within the carrying platform 20. At least three ejector pins 25 can be provided, spaced apart along the circumference of the carrying platform 20. By controlling the raising and lowering of the ejector pins 25, the tips of the at least three ejector pins 25 can be simultaneously raised to a position above the bearing surface of the carrying platform 20, or lowered to a position below the bearing surface of the carrying platform 20, thereby facilitating wafer placement and removal operations with a robotic arm.

The spray assembly 30 is positioned above the carrying platform 20, for example, directly above it. During processing, an external gas source supplies gas to the spray assembly 30, which then evenly sprays the gas into the chamber body 10. The gas forms a plasma under the influence of the radio frequency power and high temperature applied to the spray assembly 30, undergoing a chemical reaction. The resulting product is deposited as a thin film on the surface of the wafer.

At least one first distance measuring module 41 can be provided, located within the spray assembly 30. The first distance measuring module 41 measures the first distance between itself (i.e., the detection end) and the wafer on the carrying platform 20. The first distance measuring module 41 can be a laser distance measuring sensor. For example, if the first distance measuring module 41 is embedded within the spray assembly 30, and its detection end is flush with the bottom surface of the spray assembly 30, the first distance is the distance between the bottom surface of the spray assembly 30 and the wafer on the support platform 20. This first distance is equal to the gap value.

In other embodiments, the detection end of the first distance measuring module 41 can also be set on the top surface of the spray assembly 30. In this case, the Gap value is equal to the first distance minus the thickness of the spray assembly 30. This embodiment does not limit the position and setting method of the first distance measuring module 41 in the spray assembly 30. It should be noted that 1, 2, or 3 or more first distance measuring modules 41 can be set. When more than 3 are set, it is best that at least 3 first distance measuring modules 41 are not set in a collinear manner. By setting multiple first distance measuring modules 41 and distributing them at different positions of the spray assembly 30, and by calculating the average value of the first distances detected by the three first distance measuring modules 41, the Gap value can be more accurately determined.

The first drive source 51 is connected to the carrying platform 20 and is used to drive the carrying platform 20 to move up and down based on the first distance. For example, an average of the first distances measured by each first distance measuring module 41 can be calculated, and a gap value can be determined based on this average. When the gap value is greater than a preset target gap value, the first drive source 51 can be controlled to drive the carrying platform 20 upward. When the gap value is less than the preset target gap value, the first drive source 51 can be controlled to drive the carrying platform 20 downward, ensuring that the gap value is within the error range of the preset target gap value. Specifically, a control system can be used to control the first distance measuring module 41 and the first drive source 51, such as a closed-loop control system. For example, this control system can be a PLC control system. This control system is commonly used in the art and will not be described in detail in this embodiment.

Related techniques for gap value calibration involve offline calibration in atmospheric conditions, requiring manual measurement and recording of different gap values. This is time-consuming and labor-intensive. Furthermore, the gap value can change over time, and if not calibrated promptly, process uniformity can be significantly affected. This embodiment incorporates at least one first distance measuring module 41 within the spray assembly 30. The first distance measuring module 41 measures the first distance between itself and the wafer on the carrying platform 20. Based on this first distance, a gap value is derived. The first drive source 51 drives the carrying platform 20 upward or downward, calibrating the gap value if it exceeds a preset target gap error range. Throughout the entire process, the first distance measured in real time by the first distance measuring module 41 allows for timely gap calibration, ensuring consistent film thickness across wafers from different batches or at different deposition process stages. This embodiment not only facilitates gap calibration during the process but is also suitable for pre-process machine commissioning, eliminating the need for repeated chamber measurements and simplifying commissioning. Furthermore, in this embodiment, the gap calibration measurement is based on the stationary spray assembly 30, resulting in high accuracy, exceeding 0.1mm.

It should be noted that, although the first distance measuring module 41 can be set below the carrying platform 20 and a through hole is made on the carrying platform 20 to measure the distance of the spray assembly 30 above the process chamber or the wafer on the carrying platform 20, since the carrying platform 20 usually needs to be heated during the deposition process, the provision of the through hole on the carrying platform 20 will affect the temperature uniformity of the carrying platform 20, thereby affecting the deposition process.

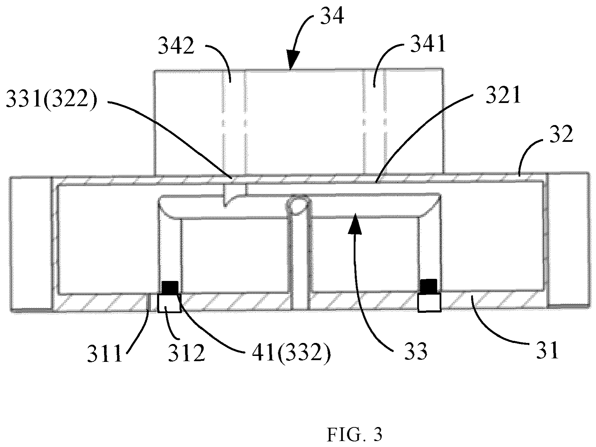

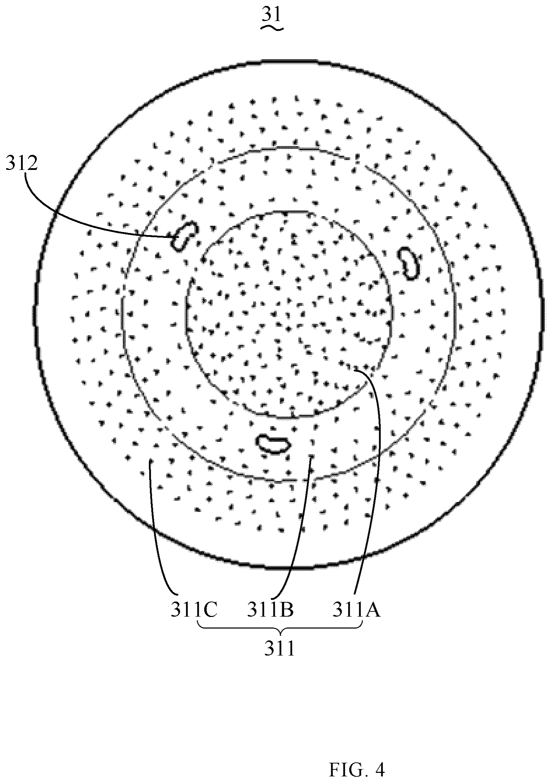

In one embodiment, the present disclosure provides a solution for installing a first distance measuring module 41 on a spray assembly 30. Please refer to FIGs. 3 and 4. FIG. 3 is a schematic diagram of the structure of a spray assembly according to an embodiment of the present disclosure, and FIG. 4 is a schematic diagram of the structure of a gas distribution plate according to an embodiment of the present disclosure. The spray assembly 30 includes a gas distribution plate 31.

The gas distribution plate 31 is internally provided with a plurality of gas distribution holes 311 that communicate with the interior of the chamber body 10. The gas distribution plate 31 includes a transparent portion 312, which is arranged to avoid the gas distribution holes 311. The first distance measuring module 41 is arranged in a one-to-one correspondence with the transparent portion. For example, the first distance measuring module 41 can be installed on the top surface of the gas distribution plate 31 and located at the corresponding transparent portion 312, or it can be installed from the top surface of the gas distribution plate 31 at least partially embedded in the transparent portion 312. As an example, the gas distribution plate 31 can be made of metal. The gas distribution holes 311 and a through-hole corresponding to the transparent portion 312 are machined on the gas distribution plate 31. The through-holes are then sealed with quartz material to form a quartz window, i.e., the transparent portion 312. The first distance measuring module 41 is disposed above the transparent portion 312 or at least partially embedded within the transparent portion 312. If the first distance measuring module 41 is a laser sensor, the emitted laser signal can pass through the transparent portion 312, and the reflected laser signal can also pass through the transparent portion 312 and be received by the first distance measuring module 41, thereby achieving distance measurement.

The spray assembly 30 also includes a sealing cover 32, which is positioned over the gas distribution plate 31 and forms a gas distributing cavity between the sealing cover 32 and the gas distribution plate 31. The sealing cover 32 is provided with gas inlet holes 321 for introducing gas into the gas distributing cavity. FIG3 only illustrates the location of the gas inlet holes 321, but because the gas inlet holes 321 are not shown in the cross-section of the sealing cover 32 shown in FIG. 3, the specific structure of the gas inlet holes 321 is not shown in the cross-section. The multiple gas distribution holes 311 are all connected to the gas distributing cavity, thereby transporting gas from the gas distributing cavity into the interior of the chamber body 10.

In this embodiment, the first distance measuring module 41 can measure the first distance through the transparent portion 312 using the principle of light sensing.

In one embodiment, referring again to FIGs. 2 and 3, the spray assembly 30 may further include an isolation pipe 33 disposed within the gas distributing cavity. The isolation pipe 33 includes an inlet end 331 and an outlet end 332 corresponding to each first distance measuring module 41. The outlet end 332 houses the corresponding first distance measuring module 41 within the isolation pipe 33. For example, the inlet end 331 extends to the top surface of the gas distribution plate 31 or the top surface of the transparent portion 312, allowing the isolation pipe 33 to house the first distance measuring module 41. The sealing cover 32 also includes a connection hole 322, with the inlet end 331 located at the connection hole 322. For example, if three first distance measuring modules 41 are provided, the isolation pipe 33 includes three branch pipes, each of which houses a first distance measuring module 41 at its outlet end 332. In use, as shown in FIG. 2, a connecting shaft 34 can be used to penetrate the top plate 11 of the chamber body 10 and connect to the top surface of the sealing cover 32. A through hole 341 communicating with the gas inlet holes 321 can be provided within the connecting shaft 34 for gas supply. A through hole 342 communicating with the connection hole 322 can also be provided within tahe connecting shaft 34 for routing the cable of the first distance measuring module 41. Specifically, the cable of the first distance measuring module 41, housed in the isolation pipe 33, can be routed through the inlet end 331, the connection hole 322, and the through hole 342 in sequence to the exterior of the spray assembly 30 for connection to an external control system. FIG. 3 only illustrates the locations of the inlet end 331 and the connection hole 322. Because these are not shown in the cross-section of the sealing cover 32 shown in FIG. 3, their specific structures are not shown in the cross-section.

Those skilled in the art will appreciate that the isolation pipe 33 may or may not be provided. For example, the first distance measuring module 41 can also transmit ranging data externally via a wireless communication module, eliminating the need for an additional isolation pipe 33 to accommodate wiring.

In this embodiment, the first distance measuring module 41 and its corresponding cables are isolated by the isolation pipe 33, completely shielded from the entire gas channel. This allows the first distance measuring module 41 to be placed in a non-radio frequency or RF (non-plasma) environment, preventing corrosion that could affect its lifespan.

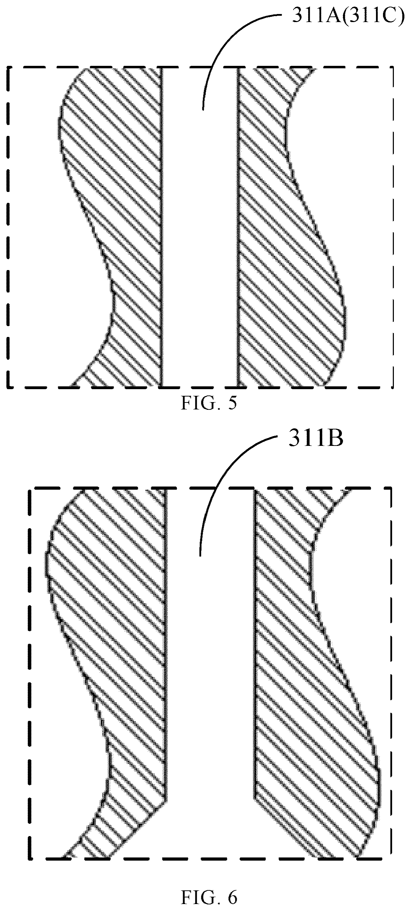

Because the first distance measuring module 41 occupies a portion of the surface area of the gas distribution plate 31, affecting the gas flow in a localized area, the present disclosure provides an embodiment of the gas distribution plate. Please refer to FIGs. 4-6. FIG. 5 is a schematic longitudinal cross-sectional view of a first through-hole according to an embodiment of the present disclosure, and FIG. 6 is a schematic longitudinal cross-sectional view of a second through-hole according to an embodiment of the present disclosure. The gas distribution plate 31 includes at least two gas distribution regions: a first gas distribution region without the first distance measuring module 41 and a second gas distribution region with the first distance measuring module 41. The gas outlets of the gas distribution holes in the first gas distribution region (hereinafter referred to as first through-holes 311A) are smaller than the gas outlets of the gas distribution holes in the second gas distribution region (hereinafter referred to as second through-holes 311B).

The presence of the first distance measuring module 41 in the second gas distribution region reduces the number of second through-holes 311B, resulting in a corresponding decrease in gas flow in the second gas distribution region. In this embodiment, by making the outlet end of the second through hole 311B larger than the outlet end of the first through hole 311A, the gas flow rate in the second gas distribution zone can be increased to compensate for the difference, thereby improving the uniformity of the gas flow rate in the gas distribution plate 31. As an example, the first through hole 311A in the first gas distribution zone is a straight hole, and the second through hole 311B in the second gas distribution zone includes a straight hole section and a variable diameter hole section arranged sequentially from the inlet end to the outlet end. The diameter of the straight hole section is substantially equal to that of the first through hole 311A, while the variable diameter hole section is, for example, an outwardly flared tapered hole, so that the outlet end of the second through hole 311B is larger than the outlet end of the first through hole 311A. Of course, in practical implementations, the second through hole 311B in the second gas distribution zone can also be a tapered hole as a whole, or any other shape, as long as the outlet end of the second through hole 311B is an outwardly flared tapered hole to increase the gas flow rate in the second gas distribution zone.

In one embodiment, the first gas distribution region includes an inner circle gas distribution region and an outer circle gas distribution region, and the second gas distribution region is a middle circle gas distribution region. The middle circle gas distribution region is arranged around the inner circle gas distribution region, and the outer circle gas distribution region is arranged around the middle circle gas distribution region.

For example, as bounded by the dashed circle in FIG. 4, the multiple gas distribution holes 311 include first through-holes 311A evenly distributed in the inner circle gas distribution region, second through-holes 311B evenly distributed in the middle circle gas distribution region, and third through-holes 311C evenly distributed in the outer circle gas distribution region. The first through-holes 311A and third through-holes 311C are straight holes, as shown in FIG. 5. The second through-hole 311B, located on the bottom surface of the gas distribution plate 31, has an outwardly flaring conical shape, as shown in FIG. 6. The first distance measuring module 41 is located in the middle gas distribution region. FIG. 4 shows three gas distribution regions: the inner circle, middle circle, and outer circle gas distribution regions. Those skilled in the art will appreciate that more or fewer gas distribution regions are also feasible.

The provision of the first distance measuring module 41 reduces the number of second through-holes 311B, resulting in a corresponding decrease in the gas flow rate in the middle circle gas distribution region. In this embodiment, the outlet end of the second through-hole 311B in the middle circle gas distribution region is designed to be tapered outward. This increases the gas flow rate in the middle circle gas distribution region to compensate for the gas flow, thereby improving the uniformity of the gas flow rate of the gas distribution plate 31.

In one embodiment, the present disclosure provides an embodiment in which a first driving source drives the lifting and lowering of a carrying platform 20. Referring again to FIG. 2, the carrying platform 20 may include a carrying plate 21 and a support base 22. The support base 22 extends through the bottom plate 12 of the chamber body 10 and is movably connected to the bottom plate 12. For example, the support base 22 may be connected to the bottom plate 12 via a bellows. The bellows seals the through-hole in the bottom plate 12 through which the support base 22 extends, ensuring a tight seal within the chamber body 10. The carrying plate 21 is disposed on top of the support base 22. The first drive source 51 is located outside the chamber body 10 and is used to drive the support base 22 to cause the carrying plate 21 to move upward and downward.

In one embodiment, the carrying platform 20 further includes a mounting plate 24 connected to the portion of the support base 22 located outside the chamber body 10. A first drive source 51 is used to drive the mounting plate to cause the carrying plate 21 to move upward and downward.

As an example, the process chamber may further include a fixed plate 60 disposed outside the chamber body 10. For example, the fixed plate 60 may be disposed on the bottom surface of the bottom plate 12 of the chamber body 10. The fixed plate 60 is provided with a vertically extending slide (not shown). The carrying platform 20 further includes a slider 23 that engages with the slide. The slider 23 is connected to the mounting plate 24. This connection may be direct or indirect via some connector, and the type of connection is not limited in this embodiment. The first drive source 51 is used to drive the carrying platform 20 to move upward and downward relative to the slide. For example, the driving force of the first drive source 51 may act on the slider 23, the mounting plate 24, or both the slider 23 and the mounting plate 24, and the type of interaction is not limited in this embodiment.

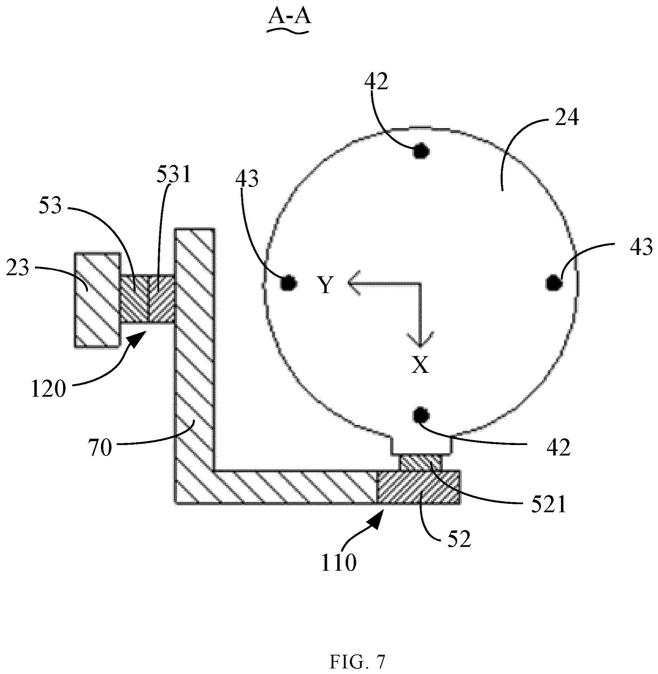

In one embodiment, the present disclosure also provides a solution for adjusting the horizontality of the carrying platform 20. The so-called horizontality refers to the degree of deviation of the supporting surface of the carrying platform 20 relative to the horizontal plane. Referring to FIGs. 2 and 7, the carrying platform 20 may also include a connecting bracket 70,
a first leveling mechanism 110, and a second leveling mechanism 120. The first leveling mechanism 110 is respectively connected to the mounting plate 24 and one end of the connecting bracket 70, and is used to adjust the horizontality of the support base 22 in a first direction (Y direction) through the mounting plate 24. The horizontality refers to the degree of deviation of the top surface of the support base 22 in the Y direction relative to the horizontal plane. The second leveling mechanism 120 is respectively connected to the slider 23 and the other end of the connecting bracket 70, and is used to adjust the horizontality of the support base 22 in a second direction (X direction) through the connecting bracket 70. The horizontality refers to the degree of deviation of the top surface of the support base 22 in the X direction relative to the horizontal plane, where the second direction is perpendicular to the first direction. The first drive source 51 can be connected to the slider 23. That is, the force of the first drive source 51 is applied to the slider 23 to drive the slider 23 to move up and down relative to the chute on the fixed plate 60, so that the slider 23 drives the mounting plate 24 to move up and down. The first drive source 51 can also be connected to the mounting plate 24. That is, the force of the first drive source 51 is applied to the mounting plate 24 to drive the slider 23 to move up and down relative to the chute on the fixed plate 60 via the mounting plate 24.

In this embodiment, the first leveling mechanism 110 and the second leveling mechanism 120 are connected via a connecting bracket 70. The first leveling mechanism 110 is connected to the mounting plate 24, directly leveling the carrying platform 20 in the Y direction. The second leveling mechanism 120 indirectly drives the carrying platform 20 via the connecting bracket 70, leveling the carrying platform 20 in the X direction. Furthermore, the mounting plate 24, the first leveling mechanism 110, the connecting bracket 70, and the second leveling mechanism 120 are all directly or indirectly connected to the slider 23, enabling the entire mechanism to be raised or lowered under the influence of the first drive source 51. This embodiment cleverly integrates the leveling and gap calibration mechanisms, resulting in a relatively simple structure and control.

As an example, the first leveling mechanism 110 may include a second drive source 52 and at least two second distance measuring modules 43 arranged along the top surface of the mounting plate 24 in a first direction (i.e., the Y direction). Each second distance measuring module 43 is used to measure the second distance between itself and the bottom plate 12. The following description uses the example of two second distance measuring modules 43 arranged symmetrically about the X axis.

The second drive source 52 is disposed on the connecting bracket 70 and connected to the mounting plate 24. For example, the second drive source 52 can be connected to the mounting plate 24 via an X-axis 521. The second drive source 52 is used to drive the mounting plate 24 to swing about a horizontal axis of the mounting plate 24 parallel to the second direction (i.e., the X direction) (i.e., the axial centerline of the X-axis 521) based on the second distances Y1 and Y2 measured by the two second distance measuring modules 43, thereby driving the support base 22 to rotate to adjust the horizontality of the support base 22 in the first direction (i.e., the Y direction). For example, if the second distance Y1 measured by the second distance measuring module 43 on the left side of FIG. 7 is greater than the second distance Y2 measured by the second distance measuring module 43 on the right side, and the difference between the two distances exceeds a preset horizontal error value, it indicates that the support base 22 corresponding to the second distance measuring module 43 on the left side is positioned too low. The second drive source 52 can be controlled to drive the mounting plate 24 to swing about a horizontal axis of the mounting plate 24 parallel to the X direction. During the swinging process, the second distance Y1 decreases while the second distance Y2 increases, thereby maintaining the carrying platform 20 horizontal in the Y direction.

As an example, the second leveling mechanism 120 may include a third drive source 53 and at least two third distance-measuring modules 42 arranged along the second direction (i.e., the X-direction) on the top surface of the mounting plate 24. Each third distance-measuring module 42 is configured to measure a third distance between itself and the bottom plate 12. The following description uses the example of two third distance-measuring modules 42 arranged symmetrically about the Y-axis.

The third drive source 53 is disposed on the slider 23 and connected to the other end of the connecting bracket 70. For example, the third drive source 53 may be connected to the connecting bracket 70 via a Y-axis 531. The third drive source 53 is configured to drive the mounting plate 24, via the connecting bracket 70, to swing about a horizontal axis parallel to the first direction (i.e., the axial centerline of the Y-axis 531) based on the third distances X1 and X2 measured by the two third distance-measuring modules 42. This allows the support base 22 to rotate relative to the bottom plate 12 (the connection between the two serves as the pivot point) to adjust the level of the support base 22 in the second direction (i.e., the X-direction). The leveling principle of the third drive source 53 in the X direction is as described above with respect to the leveling principle of the second drive source 52 in the Y direction, and will not be repeated in this embodiment.

As some examples, in this embodiment, the first drive source 51, the second drive source 52 and the third drive source 53 can be servo motors. For example, the first drive source 51 is a Z-axis servo motor, the second drive source 52 is a servo motor that rotates around the horizontal axis of the mounting plate 24 parallel to the X direction (i.e., the axial center line of the X-axis 521), hereinafter referred to as the X-axis servo motor, and the third drive source 53 is a servo motor that rotates around the horizontal axis of the mounting plate 24 parallel to the Y direction (i.e., the axial center line of the Y-axis 531), hereinafter referred to as the Y-axis servo motor. For example, the control process for the second drive source 52 to drive the mounting plate 24 to oscillate about a horizontal axis parallel to the X-direction (i.e., the axial centerline of the X-axis 521) can be as follows: When the X-axis servo motor rotates forward, the mounting plate 24 is driven to move in the -Y direction (i.e., the second distance Y1 decreases while the second distance Y2 increases). When the servo motor rotates reversely, the mounting plate 24 is driven to move in the +Y direction (i.e., the second distance Y1 increases while the second distance Y2 decreases). Of course, forward rotation of the servo motor can also correspond to a decrease in feed rate, and reverse rotation to an increase in feed rate. The second and third distance measurement modules 43 and 42 can be CCD distance measurement sensors.

In this embodiment, the second distance measuring module 43 and the third distance measuring module 42 are arranged on the top surface of the mounting plate 24, corresponding to the second distance and the third distance between the mounting plate 24 and the bottom plate 12. The second drive source 52 and the third drive source 53 are connected by a connecting bracket 70. The second drive source 52 is connected to the mounting plate 24 and can directly level the carrying platform 20 in the Y direction according to the second distance. The third drive source 53 indirectly drives the carrying platform 20 through the connecting bracket 70 and level the carrying platform 20 in the X direction according to the third distance. In addition, the mounting plate 24, the second drive source 52, the connecting bracket 70 and the third drive source 53 are all directly or indirectly connected to the slider 23 and can be raised or lowered as a whole under the action of the first drive source 51. This embodiment cleverly designs the first leveling mechanism 110 and the second leveling mechanism 120, and integrates the gap calibration structure. The overall structural connection and control are relatively simple.

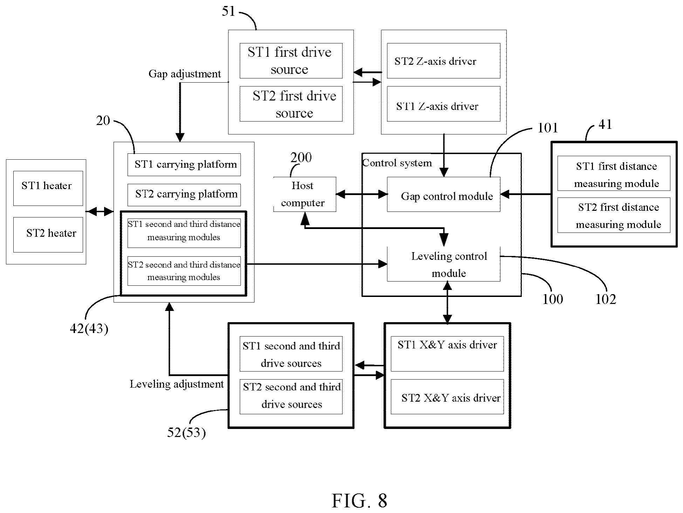

Please refer to FIG. 8, which is a schematic diagram of the structure of a control system provided in an embodiment of the present disclosure, which can be applied to the process chamber of the aforementioned embodiment. Taking the process chamber as an example, including two deposition process stations ST1 and ST2, the control system can independently control the two deposition process stations ST1 and ST2 in sequence, without interfering with each other. This embodiment uses the control of deposition process station ST1 as an example for explanation.

The control system 100 includes a gap control module 101 and a level control module 102. When the host computer 200 issues a working instruction to the level control module 102 of the control system 100, the level control module 102 controls the second distance measurement module 43 and the third distance measurement module 42 to measure the second and third distances, respectively, and calculates the level in the Y and X directions. When leveling is determined to be necessary, such as in the Y direction, the level control module 102 controls the second drive source 52 to adjust the level of the carrying platform in the Y direction until the current level calculated in real time meets the required level. When the host computer 200 issues a working instruction to the gap control module 101 of the control system, the gap control module 101 controls the first distance measurement module 41 to measure the first distance and calculate the current gap value. If it determines that the gap size adjustment is necessary, the gap control module 101 controls the first drive source 51 to adjust the height of the carrying platform 20 until the current gap value calculated in real time meets the standard.

The present disclosure also provides a semiconductor processing device including a process chamber as described in the above embodiments. For example, the semiconductor processing device can be a plasma-enhanced chemical vapor deposition device or a plasma etching device. For the corresponding operating principles and processes of the semiconductor processing device of this embodiment, please refer to the description of the process chamber in the above embodiments of the present disclosure and the description will not be repeated here.

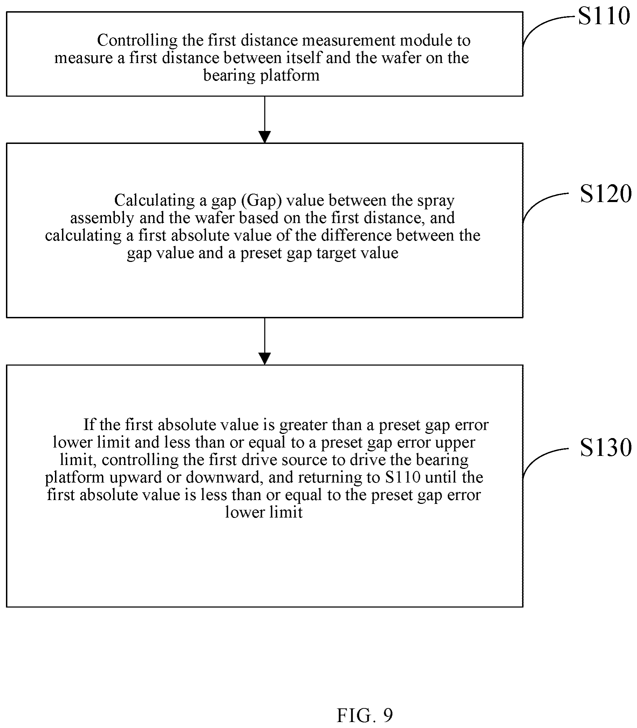

Based on the process chamber described in the above embodiments, the present disclosure also provides a method for calibrating a carrying platform. FIG. 9 is a schematic flow diagram of a gap calibration method provided by the present disclosure. The gap calibration process may include:
S110: Controlling the first distance measurement module 41 to measure a first distance between itself and the wafer on the carrying platform 20.
S120: Calculating a gap (Gap) value between the spray assembly and the wafer based on the first distance, and calculating a first absolute value of the difference between the gap value and a preset gap target value.
S130: If the first absolute value is greater than a preset gap error lower limit and less than or equal to a preset gap error upper limit, controlling the first drive source 51 to drive the carrying platform 20 upward or downward, and returning to S110 until the first absolute value is less than or equal to the preset gap error lower limit.

The gap (Gap) value between the spray assembly and the wafer is G = L - T', where L is the first distance measured by the first distance measurement module 41 and T' is the thickness of the gas distribution plate 31, which is a constant value. Therefore, measuring the first distance L is equivalent to indirectly obtaining the G value. For ease of description, the following description directly describes the measurement of the G value by the first distance measurement module 41. This should be understandable.

After measuring the G value, it can be compared with the preset gap target value G0. Specifically, the first absolute value ΔG = |G - G0| can be calculated. If the first absolute value ΔG is less than or equal to the preset gap error lower limit (Gmin), the G value is within the standard range. If the first absolute value ΔG is greater than the preset gap error lower limit and less than or equal to the preset gap error upper limit (Gmax), the G value is outside the standard range. The first drive source 51 can be controlled to drive the carrying platform 20 upward or downward until ΔG ≤ Gmin.

Furthermore, after S120, the following may be included:
S140: If the first absolute value ΔG is greater than the preset gap error upper limit, a process chamber abnormality is determined, and abnormal event handling is performed on the process chamber.

During the pre-process calibration process, since the distance L between the initial position of the carrying platform 20 and the showerhead 30 and the wafer thickness T are fixed, the distance D of the carrying platform 20's rise is controlled with high precision. After the initial calibration, if ΔG > Gmax, this indicates a significant deviation from G0. This can be preliminarily diagnosed as a process chamber abnormality, such as the presence of particles on the carrier platform. In this case, the process chamber can be opened for inspection or cleaning. Similarly, during the process, if the Gap value suddenly deviates significantly from G0, similar measures can be taken.

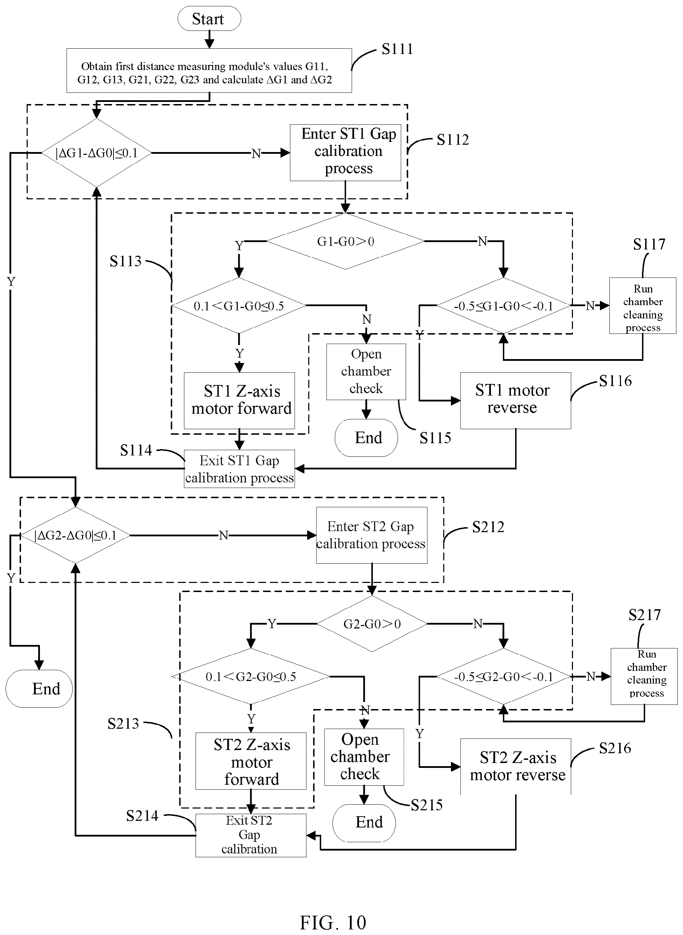

See FIG. 10, which is a schematic flow diagram of another gap calibration method provided by an embodiment of the present disclosure. The semiconductor processing device includes two deposition process stations ST1 and ST2, each equipped with three first distance measuring modules 41. The preset gap target value is G0, the preset gap error lower limit Gmin = 0.1 mm, and the preset gap error upper limit Gmax = 0.5 mm. The gap calibration method includes:
S111: Controlling three first distance measurement modules 41 at two deposition process stations ST1 and ST2 to measure corresponding G values. The three G values at deposition process station ST1 are G11, G12, and G13, respectively; and the three G values at deposition process station ST2 are G21, G22, and G23, respectively. Calculating an average value G1 and a first absolute value ΔG1 = |G1 - G0| of G11, G12, and G13 at deposition process station ST1; and calculating an average value G2 and a first absolute value ΔG2 = |G2 - G0| of G21, G22, and G23 at deposition process station ST2.
S112: If |G1-G0| > 0.1, then proceed to the gap calibration process for deposition process station ST1; otherwise, execute S212.
S113: If G1-G0 > 0 and 0.1 < G1-G0 ≤ 0.5, then control the Z-axis servo motor of deposition process station ST1 to rotate forward.

If G1-G0 > 0 and G1-G0 > 0.5, then execute S115.

If G1-G0 < 0 and -0.5 ≤ G1-G0 < -0.1, then execute S116.

If G1-G0 < 0 and G1-G0 < -0.5, then execute S117.

S114: Exit the gap calibration process for deposition process station ST1 and return to S112.

S115: Perform a chamber inspection, and then complete the calibration process.

S116: Control the Z-axis servo motor of deposition process station ST1 to rotate in the reverse direction, and return to S114.

S117: Perform the chamber cleaning process, and return to S113.

S212: If |G2 - G0| > 0.1, proceed to the gap calibration process of deposition process station ST2; otherwise, terminate the entire calibration process.

S213: If G2 - G0 > 0, and 0.1 < G2 - G0 ≤ 0.5, control the Z-axis servo motor of deposition process station ST2 to rotate in the forward direction
If G2 - G0 > 0 and G2 - G0 > 0.5, execute S215;
If G2 - G0 < 0 and -0.5 ≤ G2 - G0 < -0.1, execute S216;
If G2 - G0 < 0 and G2 - G0 < -0.5, execute S217;
S214: Exit the gap calibration process for deposition process station ST2 and return to S212;
S215: Open chamber inspection and terminate the calibration process.
S216: Control the Z-axis servo motor of deposition process station ST2 to reverse direction and return to S214;
S217: Execute the chamber cleaning process and return to S213.

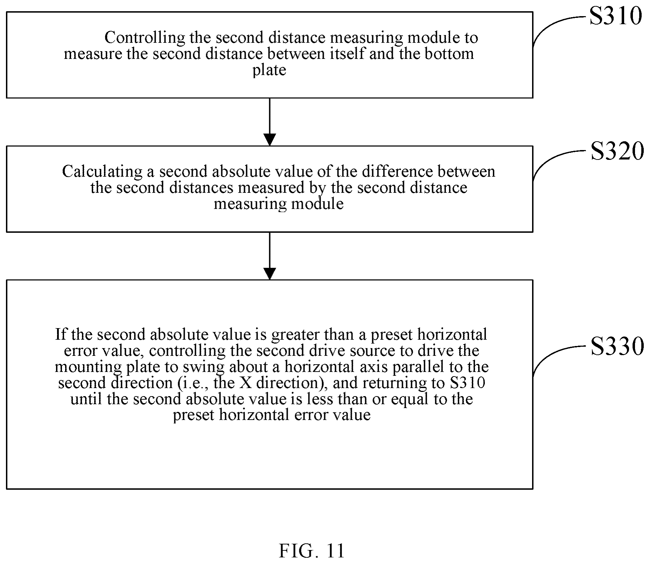

In one embodiment, before the process begins and before performing gap calibration, the carrying platform 20 may be leveled. Please refer to FIG. 11, which is a schematic flow diagram of a horizontal calibration method in a first direction (i.e., the Y direction) provided by an embodiment of the present disclosure. The horizontal calibration process includes:
S310: Controlling the second distance measuring module 43 to measure the second distance between itself and the bottom plate 12;
S320: Calculating a second absolute value of the difference between the second distances measured by the second distance measuring module 43;
S330: If the second absolute value is greater than a preset horizontal error value, controlling the second drive source 52 to drive the mounting plate 24 to swing about a horizontal axis parallel to the second direction (i.e., the X direction), and returning to S310 until the second absolute value is less than or equal to the preset horizontal error value.

For example, assuming two second distance measuring modules 43 are provided, symmetrically arranged on either side of the X-axis, the two second distance measuring modules 43 measure second distances Y1 and Y2, respectively. The second absolute value ΔY = |Y2 - Y1| of the difference between the two second distances Y1 and Y2 is then calculated. If the second absolute value ΔY is greater than the preset horizontal error value δ, it indicates that the carrying platform 20 is tilted in the Y direction and requires calibration. The second drive source 52 can be controlled to drive the mounting plate 24 to swing about a horizontal axis parallel to the X-direction until the recalculated ΔY ≤ δ.

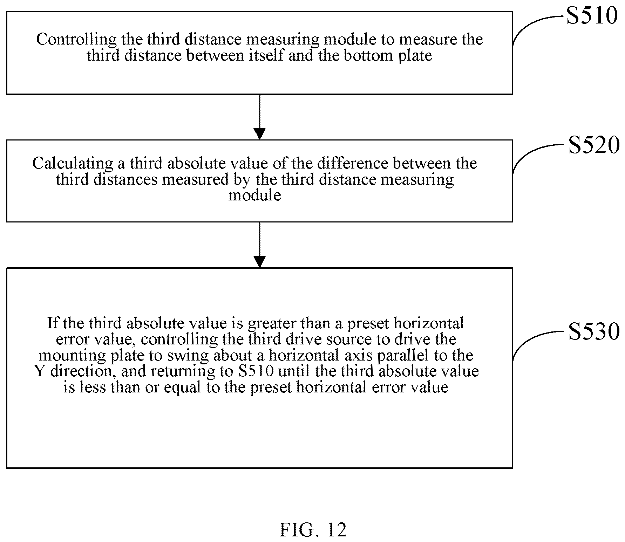

Similarly, horizontal calibration of the carrying platform 20 in the second direction (i.e., the X-direction) can be performed. This can be performed before S310 or after S330. Please refer to FIG. 12, which is a schematic flow chart of a second-direction horizontal calibration method provided by an embodiment of the present disclosure. This horizontal calibration method may include:
S510: Controlling the third distance measuring module 42 to measure the third distance between itself and the bottom plate 12;
S520: Calculating a third absolute value of the difference between the third distances measured by the third distance measuring module 42;
S530: If the third absolute value is greater than a preset horizontal error value, controlling the third drive source 53 to drive the mounting plate 24 to swing about a horizontal axis parallel to the Y direction, and returning to S510 until the third absolute value is less than or equal to the preset horizontal error value.

For example, assuming two third distance measuring modules 42 are provided, symmetrically arranged on either side of the Y-axis, the two third distance measuring modules 42 measure the third distances X1 and X2, respectively. The second absolute value ΔX = |X2 - X1| of the difference between the two second distances X1 and X2 is then calculated. If the second absolute value ΔX is greater than the preset horizontal error value δ, it indicates that the carrying platform 20 is tilted in the X-direction and requires calibration. The third drive source 53 can be controlled to drive the mounting plate 24 to swing about a horizontal axis parallel to the Y-direction until the recalculated ΔX ≤ δ.

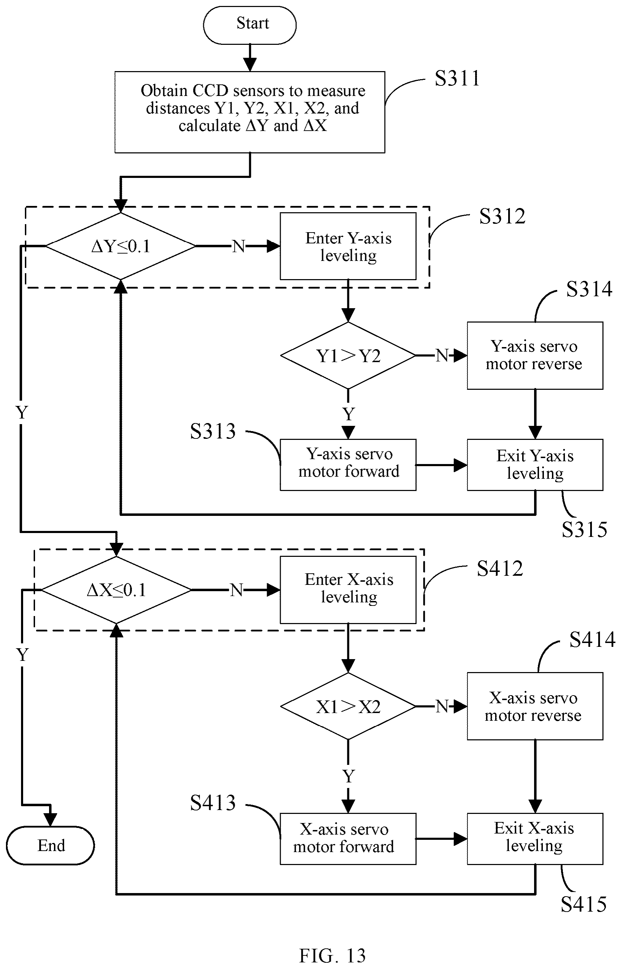

Please refer to FIG. 13, which is a schematic flow diagram of a horizontal calibration method provided by an embodiment of the present disclosure. The semiconductor processing device includes a deposition process station, two second distance measuring modules 43, and two third distance measuring modules 42, each of which is a CCD distance measurement sensor. A preset horizontal error value δ = 0.1 mm is used. The horizontal calibration method includes:
S311: Controlling the four CCD distance measuring sensors to measure two second distances Y1 and Y2, and two third distances X1 and X2, respectively, and calculating a second absolute value ΔY = |Y2 - Y1| and a third absolute value ΔX = |X2 - X1|.
S312: If ΔY > 0.1, proceed to the Y-axis horizontal calibration process; otherwise, execute S412.
S313: If Y1 > Y2, control the Y-axis servo motor to rotate forward; otherwise, execute S314.
S314: Control the Y-axis servo motor to rotate reversely.
S315: Exit the Y-axis leveling process and return to S312.
S412: If ΔX > 0.1, proceed to the X-axis horizontal calibration process; otherwise, terminate the entire leveling process.
S413: If X1 > X2, control the X-axis servo motor to rotate forward; otherwise, execute S414.
S414: Control the X-axis servo motor to rotate reversely.
S415: Exit the X-axis leveling process and return to S412.

It should be noted that the gap calibration and leveling calibration processes described in the aforementioned embodiments of the present disclosure not only automate pre-process leveling and gap adjustment but also improve implementation scenarios such as wafer loading and unloading processes, as detailed below.

Implementation Scenario 1: When adjusting the gap of the carrying platform 20, manual leveling using the AGS leveling tool is no longer necessary. Instead, the gap calibration process is performed. The first distance is measured by the first distance measuring module 41, and the carrying platform 20 is raised and lowered according to the first drive source 51 to complete the gap adjustment. This automated process reduces manual adjustment errors, eliminates the need for repeated chamber openings, and simplifies the adjustment process.

Implementation Scenario 2: During processing in the process chamber, the gap calibration and leveling calibration processes can be performed to achieve real-time wafer leveling and gap value calibration, ensuring process film deposition rate and film uniformity within and between wafers. For example, at the beginning of the process, the carrying platform 20 is at the lowest position. At this time, the horizontal calibration process is executed to ensure the level of the carrying platform 20. Then the gap value is set, and the carrying platform 20 is controlled to rise to the set value. The horizontal calibration process is executed again, and finally the gap calibration process is executed to ensure that in each process, the wafer level meets the requirements and the actual gap value is within the error range of the set value.

Implementation Scenario 3: The existing wafer retrieval process involves first lowering the carrying platform 20 to its lowest point, automatically lifting the wafer with at least three ejector pins 25. The process chamber valve is then opened, and the robotic arm enters the chamber at a low position to retrieve the wafer. If the carrying platform 20 itself is not level or the three ejector pins 25 are at different heights, the wafer's position can easily shift, potentially preventing the robotic arm from retrieving the wafer or even causing the robotic arm to collide with the wafer. Applying the two calibration processes of the disclosed embodiments, when removing a wafer, the leveling process can be first performed. The carrying platform 20 is then controlled to descend to its lowest point. At this point, D = 0 and G = L. The first distance measured by the first distance measuring module 41 is then used to determine whether the wafer is level. If |G¬ - G0| ≤ 0.1mm, the wafer is considered level, and the robot removes the wafer normally. If 0.1mm < |G¬ - G0| ≤ 0.5mm, the leveling process is performed to ensure |G¬ - G0| ≤ 0.1mm, and the robot removes the wafer. If |G¬ - G0| > 0.5mm, the wafer removal process is canceled, and the chamber is opened to check the status of the heater and at least three ejector pins 25.

Implementation Scenario 4: The existing wafer placement process is as follows: the carrying platform 20 descends to its lowest point, at least three ejector pins 25 are raised, the gate valve is opened, and the robot carries the wafer into the chamber at a high position, where it then places the wafer. In implementation scenario 3, the wafer-taking process has ensured that at least three ejector pins 25 are of the same height. If the level of the carrying platform 20 does not meet the requirements, the carrying platform 20 will rise directly after the wafer is placed, and the wafer may fall on the surface of the non-level carrying platform 20 and may also be offset. To address this problem, the horizontal calibration process of the embodiment of the present disclosure is optimized as follows: when placing the wafer on the machine, the carrying platform 20 is lowered to the lowest point, the horizontal adjustment process is performed, and then the gate valve is opened, and the robot carries the wafer into the chamber at a high position to perform the wafer placement action. This can ensure that the wafer falls on the horizontal heater surface to avoid slipping.

The above describes in detail the process chamber, semiconductor processing device, and platform calibration method provided by the present disclosure. Specific examples are used herein to illustrate the principles and implementation methods of the present disclosure. It should be noted that the descriptions of each embodiment in this disclosure each focus on its own. For portions not detailed or described in a particular embodiment, reference should be made to the relevant descriptions of other embodiments.

The various technical features of the present disclosure can be combined in any manner. To maintain brevity, not all possible combinations of the technical features in the above embodiments are described. However, as long as these combinations do not conflict, they should be considered within the scope of the present disclosure.

The above are merely preferred embodiments of the present disclosure and are not intended to limit the scope of the present disclosure. Any equivalent structures or equivalent processes that utilize the contents of this disclosure and its accompanying drawings, or that are directly or indirectly applied to other related technical fields, are also included within the scope of the present disclosure.

## Claims

1. A process chamber, comprising a chamber body and at least one process station disposed within the chamber body, **characterized in that** each process station includes a carrying platform movably connected to the chamber body and a spray assembly disposed above the carrying platform, the process chamber further comprises:
at least one first distance measuring module disposed in the spray assembly, configured to measure a first distance between the spray assembly and a wafer on the carrying platform;
a first drive source connected to the carrying platform, configured to drive the carrying platform to move up and down based on the first distance.

2. The process chamber according to claim 1, **characterized in that** the spray assembly comprises:
a gas distribution plate having a plurality of gas distribution holes disposed inside and communicating with an interior of the chamber body, the gas distribution plate including a transparent portion disposed to avoid the gas distribution holes, and the first distance measuring module being disposed in a one-to-one correspondence with the transparent portion.

3. The process chamber according to claim 2, wherein the spray assembly further comprises:
a sealing cover disposed over the gas distribution plate, forming a gas distributing cavity between the sealing cover and the gas distribution plate, the sealing cover is provided with an inlet hole for introducing gas into the gas distributing cavity; the plurality of the gas distribution holes are connected to the gas distributing cavity.

4. The process chamber according to claim 3, wherein the spray assembly further comprises:
an isolation pipe disposed within the gas distributing cavity, the isolation pipe has an inlet end and an outlet end corresponding to the at least one first distance measuring module, the outlet end houses the corresponding first distance measuring module within the isolation pipe, the sealing cover is further provided with a connection hole, the inlet end is located at the connection hole, the isolation pipe is used to accommodate a cable of the first distance measuring module.

5. The process chamber according to claim 2, wherein the gas distribution plate includes at least two gas distribution regions, the at least two gas distribution regions including a first gas distribution region not provided with the first distance measuring module and a second gas distribution region provided with the first distance measuring module, wherein a gas outlet end of the gas distribution holes in the first gas distribution region is smaller than a gas outlet end of the gas distribution holes in the second gas distribution region.

6. The process chamber according to claim 5, wherein the gas distribution holes in the first gas distribution region are straight holes;
the gas distribution holes in the second gas distribution region have outwardly flaring conical outlet ends.

7. The process chamber according to claim 5, wherein the first gas distribution region includes an inner circle gas distribution region and an outer circle gas distribution region, and the second gas distribution region includes a middle circle gas distribution region;
the middle circle gas distribution region is disposed around the inner circle gas distribution region, and the outer circle gas distribution region is disposed around the middle circle gas distribution region.

8. The process chamber according to any one of claims 1-7, wherein the carrying platform includes a carrying plate and a support base, the support base extending through a bottom plate of the chamber body and movably connected to the bottom plate, and the carrying plate is disposed on a top surface of the support base;
the first drive source is located outside the chamber body and is configured to drive the support base to cause the carrying plate to move upward and downward.

9. The process chamber according to claim 8, **characterized in that** the process chamber further includes a fixed plate disposed outside the chamber body, the fixed plate being provided with a sliding groove extending in a vertical direction;
the carrying platform further includes a mounting plate connected to a portion of the support base located outside the chamber body, and a slider engaged with the sliding groove, the slider being connected to the mounting plate;
the first drive source is connected to the slider and/or the mounting plate to enable the slider to move up and down along the sliding groove.

10. The process chamber according to claim 9, **characterized in that** the carrying platform further includes a connecting bracket;
a first leveling mechanism is respectively connected to the mounting plate and one end of the connecting bracket, for adjusting horizontality of the support base in a first direction via the mounting plate;
a second leveling mechanism is respectively connected to the slider and another end of the connecting bracket, for adjusting horizontality of the support base in a second direction via the connecting bracket, wherein the second direction is perpendicular to the first direction.

11. The process chamber according to claim 10, wherein the first leveling mechanism includes:
at least two second distance measuring modules arranged along the first direction on a top surface of the mounting plate, the second distance measuring modules being configured to measure a second distance between the second distance measuring modules and the bottom plate;
a second drive source, disposed on the connecting bracket and connected to the mounting plate, being configured to drive the mounting plate to swing about a horizontal axis of the mounting plate parallel to the second direction based on the second distance; and/or
the second leveling mechanism includes:
at least two third distance measuring modules arranged along the second direction on the top surface of the mounting plate, the third distance measuring modules being configured to measure a third distance between the third distance measuring modules and the base plate;
a third drive source, disposed on the slider and connected to another end of the connecting bracket, being configured to drive the mounting plate to swing about a horizontal axis of the mounting plate parallel to the first direction through the connecting bracket based on the third distance.

12. A semiconductor processing device, **characterized by** comprising the process chamber according to any one of claims 1 to 11.

13. A method for calibrating a carrying platform based on the process chamber according to any one of claims 1 to 11, **characterized by** comprising a gap calibration process, the gap calibration process comprising:
controlling the first distance measurement module to measure a first distance between itself and the wafer on the carrying platform;
calculating a gap value between the spray assembly and the wafer based on the first distance, and calculating a first absolute value of the difference between the gap value and a preset gap target value;
if the first absolute value is greater than a preset gap error lower limit and less than or equal to a preset gap error upper limit, controlling the first drive source to drive the carrying platform upward or downward, and returning to controlling the first distance measuring module to measure the first distance between itself and the wafer on the carrying platform until the first absolute value is less than or equal to the preset gap error lower limit.

14. The method for calibrating the carrying platform according to claim 13, **characterized by**, after calculating the gap value between the spray assembly and the wafer based on the first distance and calculating the first absolute value of the difference between the gap value and the preset gap target value, further comprising:
if the first absolute value is greater than the preset gap error upper limit, determining that the process chamber is abnormal.

15. The method for calibrating the carrying platform according to claim 13, **characterized in that** the gap calibration process also includes a horizontal calibration process before the gap calibration process, wherein the horizontal calibration process comprises:
controlling the second distance measuring module to measure a second distance between itself and the bottom plate;
calculating a second absolute value of the difference between the second distance measured by the second distance measuring module;
if the second absolute value is greater than a preset horizontal error value, controlling the second drive source to drive the mounting plate to swing about a horizontal axis parallel to the second direction of the mounting plate, and returning to controlling the second distance measuring module to measure the second distance between itself and the bottom plate, until the second absolute value is less than or equal to the preset horizontal error value.

16. The method for calibrating the carrying platform according to claim 15, **characterized in that** before controlling the second distance measuring module to measure the second distance between itself and the base plate, or if the second absolute value is greater than a preset horizontal error value, controlling the second drive source to drive the mounting plate to swing about a horizontal axis of the mounting plate parallel to the second direction, and returning to controlling the second distance measuring module to measure the second distance between itself and the bottom plate until the second absolute value is less than or equal to the preset horizontal error value, the method further comprises:
controlling the third distance measuring module to measure a third distance between itself and the bottom plate;
calculating a third absolute value of the difference between the third distance measured by the third distance measuring module;
if the third absolute value is greater than the preset horizontal error value, controlling the third drive source to drive the mounting plate to swing about a horizontal axis of the mounting plate parallel to the first direction, and returning to controlling the third distance measuring module to measure the third distance between itself and the bottom plate until the third absolute value is less than or equal to the preset horizontal error value, wherein the second direction is perpendicular to the first direction.
